(19) Europäisches Patentamt
European Patent Office
Office européen des brevets

(11) EP 1 162 063 B1

(12) # EUROPEAN PATENT SPECIFICATION

(45) Date of publication and mention of the grant of the patent:
**10.08.2011 Bulletin 2011/32**

(51) Int Cl.:
***G03F 7/42*** (2006.01) ***B41C 1/10*** (2006.01)
***C08L 61/06*** (2006.01) ***G03F 7/023*** (2006.01)

(21) Application number: **01112912.9**

(22) Date of filing: **05.06.2001**

(54) **Planographic printing plate and light-sensitive image-forming composition comprising a recurring xylenol unit-containing novolac resin.**

Flachdruckplatte and lichtempfindliche Bilderzeugungszusammensetzung enthaltend ein Novolak-Harz mit wiederkehrenden Einheiten von Xylenol.

Plaque d'impression planographique et composition photosensible pour la formation d'images comprenant une résine novolaque ayant des unités récurrentes de xylenol.

(84) Designated Contracting States:
**AT BE CH CY DE DK ES FI FR GB GR IE IT LI LU MC NL PT SE TR**

(30) Priority: **05.06.2000 JP 2000167433**

(43) Date of publication of application:
**12.12.2001 Bulletin 2001/50**

(73) Proprietor: **FUJIFILM Corporation**
**Minato-ku**
**Tokyo (JP)**

(72) Inventor: **Kawauchi, Ikuo**
**Yoshida-cho,**
**Haibara-gun,**
**Shizuoka-ken (JP)**

(74) Representative: **HOFFMANN EITLE**
**Patent- und Rechtsanwälte**
**Arabellastraße 4**
**81925 München (DE)**

(56) References cited:
**EP-A- 0 823 327** **EP-A- 0 890 879**
**EP-A- 0 900 653** **EP-A- 0 934 822**
**EP-A- 0 943 451** **EP-A- 0 950 513**
**EP-A- 0 950 517** **EP-A- 0 978 376**
**EP-A1- 0 950 518** **EP-A1- 0 997 272**
**WO-A-00/29214** **US-A1- 2002 058 207**

- **DATABASE WPI Week 198734, Derwent Publications Ltd., London, GB; AN 1987-239340 & JP 62 163055 A (KONISHIROKU PHOTO IND CO LTD) 18 July 1987**

Remarks:
The file contains technical information submitted after the application was filed and not included in this specification

EP 1 162 063 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

BACKGROUND OF THE INVENTION

Field of the Invention

The present invention relates to a positive planographic printing master plate which may be used as an offset printing master, and particularly to a positive planographic printing master plate for so-called direct plate-making which enables plate-making directly from digital signals of a computer or the like.

Description of the Related Art

Significant progress has been made with lasers in recent years. Of solid lasers and semiconductor lasers having a light emission region from the near infrared region to the infrared region, those having high output power and a small size have come to be easily available. These lasers are very useful as light sources for exposure in plate-making directly from digital data of computers and the like.

In positive light-sensitive image forming materials for infrared lasers used for conventionally known direct plate-making, a novolac resin is used as a resin soluble in an aqueous alkali solution. For example, a positive light-sensitive image-forming material disclosed in JP-A No. 7-285275 is produced by adding a material which absorbs light to generate heat and a positive light-sensitive compound, such as various onium salts and quinonediazide compounds, to an aqueous alkali solution-soluble resin, such as a novolac resin, the resin having a phenolic hydroxyl group. The positive light-sensitive compound works in an image portion as an anti-dissolution agent which substantially decreases solubility of an aqueous alkali solution-soluble resin, and in a non-image portion develops no anti-dissolution ability but becomes development-removable due to heat. An image can thus be formed.

Also, a positive light-sensitive image-forming material described in WO97/39894 and EP0823327A2 comprises a material which absorbs light to generate heat and a resin whose solubility in an aqueous alkali solution is changed by heat. The resin has poor solubility in an aqueous alkali solution in the image portion, but is increased in solubility in an aqueous alkali solution and becomes removable by developing due to heat in the non-image portion, and thus an image can be formed.

In planographic printing plates currently in use, a novolac resin is particularly preferably used for the reason that it has a large difference in solubility in a developing solution between the exposed portion and the unexposed portion and high ink-receiving ability because it strongly interacts with an anti-dissolution agent. A novolac resin is preferably also used in positive light-sensitive image-forming materials for an infrared laser for the same reason.

However, when a positive light-sensitive image-forming material using such a novolac resin is put in a molten condition and applied to a suitable support, dried and solidified to form a light-sensitive layer, thereby manufacturing a planographic printing plate, there is a problem concerning aging stability, that is, a reduction in sensitivity with the passing of time after the planographic printing plate has been manufactured. To deal with this problem, techniques for improving stability and printing durability by increasing the molecular weight of a novolac resin to be used have been proposed. However, because novolac resins currently in use are synthesized by reacting phenols with aldehydes using an acid as a catalyst, and the phenols are trifunctional, these resins pose the problem that a branched structure in the resin increases with an increase in the molecular weight of the resin to form a gel. In the case of using the resin for a planographic printing plate, the sensitivity is decreased when the molecular weight exceeds 10,000 and it is difficult to manufacture the planographic printing plate substantially stably.

EP-A-0 823 327 relates to a positive photosensitive composition showing a difference in solubility in an alkali developer between an exposed portion and a non-exposed portion, which comprises, as components inducing the difference in solubility, (a) a photo-thennal conversion material, and (b) a high molecular compound, of which the solubility in an alkali developer is changeable mainly by a change other than a chemical change.

EP-A-0 950 517 relates to a heat mode imaging element for providing a lithographic printing plate consisting of a lithographic base with a hydrophilic surface and a top layer that is sensitive to IRradiation, comprises a polymer soluble in an aqueous alkaline solution, and is unpenetrable for an aqueous alkaline developer, characterized in that said top layer comprises a polysiloxane surfactant.

WO 00/29214 A describes a positive photosensitive printing plate wherein the photosensitivity is to near-infrared rays which do not induce a chemical change in a photosensitive component. The photosensitive material has an inclined structure from the viewpoint of dissolution of the irradiated portion in an alkali developer. The dissolution rate is such that it continuously increases from the upper, surface part of the photosensitive material to the lower part of the photosensitive material.

EP-A-0 943 451 describes a heat mode imaging element for making a lithographic printing plate having on a lithographic base with a hydrophilic surface a first layer including a polymer, soluble in an aqueous alkaline solution and

a top layer on the same side of the lithographic base as the first layer which top layer is unpenetrable for or insoluble in an alkaline developer containing $SiO_2$ in the form of silicates ; characterized in that said first layer and said top layer comprise a compound capable of converting IR-light into heat.

EP-A-0 900 653 relates to a positive-working, infrared (IR) sensitive mixture having a water-insoluble binder that dissolves or at least swells in aqueous alkali and containing dispersed carbon black particles, forms the radiation-sensitive component for differentiation of an image.

EP-A-0997272 relates to a heat mode imaging element for making a lithographic printing plate comprising on a lithographic base with a hydrophilic surface a first layer including a polymer, soluble in an aqueous alkaline solution and a top layer on the same side of the lithographic base as the first layer which top layer is IR-sensitive and unpenetrable for an alkaline developer wherein said first layer and said top layer may be one and the same; characterized in that said top layer contains at least one blockcopolymer in an amount between 0,5 and 500 mg/$m^2$.

Also, in WO99/21715, a method in which a light-sensitive layer is applied to a support and dried, and then heat-treated for several days to forcibly change and stabilize the layer. However, this method poses the problem that it has poor adaptability for manufacturing, taking required time and energy into consideration. Therefore, image-forming materials which allow both sensitivity and aging stability and which have high adaptability for manufacturing have been desired.

## SUMMARY OF THE INVENTION

It is an object of the present invention to provide a positive planographic printing plate which has high sensitivity, has limited reduction in sensitivity with over and has high aging stability.

The inventors of the present invention have made studies to attain the above object, as a result, have found that material change of a novolac resin caused by entropy relaxation over time can be efficiently prevented by using an aromatic ring having many substituents as a monomer that forms the novolac resin, and have completed the present invention.

Further, a positive planographic printing plate according to the present invention is defined in claim 5, and, has a light-sensitive layer, which comprises an alkali soluble resin containing, a novolac resin having recurring units derived from at least one xylenol selected from 3,5-xylenol and 2,3-xylenol and a material which absorbs light and generates heat which is a dye or pigment, formed on a support.

Also, the present invention provides a light-sensitive image-forming composition used for positive image recording which comprises said novolac resin and said material which absorbs light and generates heat, as defined in claim 1.

Although the action of the light-sensitive image-forming composition of the present invention is not clear, it is thought to be as follows. Xylenol, which is a monomer constituting a novolac resin, has more functional groups than a usual phenol monomer. The presence of such a structural unit in molecules ensures that the novolac resin can exist stably in the light-sensitive layer, similarly to the case of increasing the molecular weight of the novolac resin, but, unlike the case of increasing the molecular weight of the novolac resin itself, a reduction in solubility is not observed. It is therefore considered that high sensitization and aging stability can be attained at the same time.

## DETAILED DESCRIPTION OF THE PREFERRED EMBODIMENTS

The present invention will be hereinafter explained in detail.

### *Novolac resin containing recurring units derived from 3,5 - or 2,3- xylenol*

A planographic printing master plate according to the present invention includes a novolac resin (hereinafter referred to as a recurring a xylenol unit-containing novolac resin, as the case may be) that contains recurring units derived from at least one xylenol selected from 3,5-xylenol and 2,3-xylenol for the formation of a light-sensitive layer.

The novolac resin according to the present invention may be synthesized through a usual reaction process in which phenol is reacted with formaldehyde in the presence of an acid catalyst under normal pressure. The novolac resin according to the present invention is characterized by the use of a specific xylenol either in addition to or in place of phenol and cresol as a monomer to be used as a starting material.

Xylenol in the novolac resin used in the present invention is selected from the group consisting of 3,5-xylenol and 2,3-xylenol. These have relatively high melting points and are preferable in view of improvement in stability.

The weight average molecular weight of the recurring xylenol unit-containing novolac resin is preferably 500 to 10, 000. In a case where the weight average molecular weight is less than 500, only an insufficient effect of improving printing durability is obtained, whereas in a case where the weight average molecular weight exceeds 10,000, the developing ability tends to be decreased. Therefore, both these cases are undesirable.

No particular limitation is imposed on the content amount of the recurring units derived from said xylenol monomer. Even if the amount is small, the effect of improving aging stability will be observed, and is improved with increased amounts of xylenol. If the proportion of the recurring xylenol unit -containing novolac resin in an alkali-soluble resin that forms the light-sensitive layer of the planographic printing master plate of the present invention is designated Y% by weight and the content of the xylenol monomer in the novolac resin is designated X% by weight, $X \times Y$ is preferably 500 or more ($X \times Y \geqq 500$). Specifically, if all of the alkali-soluble resin is the recurring xylenol-unit containing novolac resin (Y = 100% by weight), xylenol is preferably contained in an amount of 5% by weight or more in the novolac resin in view of effectiveness.

It is found that the developing ability tends to be decreased with increased amounts of xylenol. However, in this case, a good image can be formed by regulating activity of a developing agent. Also, because the printing durability tends to be improved with decreased developing ability, the content of xylenol may be selected appropriately according to the characteristics of the planographic printing master plate to be used.

The above recurring xylenol unit-containing novolac resin is used in an amount of 10 to 99% by weight, preferably 15 to 95% by weight and particularly preferably 20 to 90% by weight in the total solids of the positive light-sensitive image-forming composition (hereinafter referred to as "image-forming composition" on occasion) that forms the light-sensitive layer of the planographic printing master plate of the present invention. If the amount of the alkali-soluble polymer compound to be added is less than 30% by weight, the durability of the recording layer will be impaired, and an amount exceeding 99% by weight is undesirable in view of both sensitivity and durability. It is to be noted that in the case where a composition obtained by mixing "an alkali-soluble resin other than the recurring xylenol unit-containing novolac resin according to the present invention", described later, with the recurring xylenol unit-containing novolac resin according to the present invention is used as a binder to prepare the image-forming composition of the present invention, the binder as a whole is preferably contained in the total solid content of the image-forming composition within the above-defined range. *Alkali-soluble resin other than the recurring xylenol unit-containing novolac resin according to the present invention*

In the present invention, the aforementioned specific novolac resin is essential as the binder and may be used in combination with other alkali-soluble resins insofar as the effects of the present invention are not impaired.

Examples of other alkali-soluble resins (hereinafter referred to simply as "other alkali-soluble resins") which may be used by mixing with the above novolac resin include various alkali-soluble polymer compounds such as known and common novolac resins (containing no xylenol monomer), phenol-modified xylene resins, polyhydroxystyrene, polyhydroxystyrene halide, acrylic resins having a phenolic hydroxyl group as disclosed in the publication of JP-A No. 51-34711, acrylic resins containing a sulfonamide group as described in the publication of JP-A No. 2-866 and urethane type resins.

Examples of common novolac resins having a weight average molecular weight of about 12,000 or less which may be used in the present invention include conventionally known novolac resins such as phenolformaldehyde resins and cresolformaldehyde resins, e.g., m-cresolformaldehyde resins, p-cresolformaldehyde resins, o-cresolformaldehyde resins, m-/p-mixed cresolformaldehyde resins and phenol/cresol (which may be any one of m-, p-, o- or mixed m-/p-, m-/o- or o-/p-) mixed formaldehyde resins.

As the urethane type resin, compounds described in the publications of JP-A Nos. 63-124047, 63-261350, 63-287942, 63-287943, 63-287944, 63-287946, 63-287947, 63-287948, 63-287949, 1-134354 and 1-255854 are preferably used.

In the present invention, particularly preferable examples of the other alkali-soluble resin include polymer compounds having any one functional group of (a-1) phenolic hydroxyl groups, (a-2) sulfonamide groups and (a-3) active imide groups. For example, the following compounds may be exemplified.

As the polymer compound having the aforementioned (a-1) phenolic hydroxyl group, polymer compounds having a phenolic hydroxyl group at a side chain may be used. Examples of the polymer compound having the phenolic hydroxyl group at the side chain include polymer compounds obtained either by homopolymerizing a polymerizable monomer that includes a low molecular weight compound having one or more phenolic hydroxyl groups and one or more polymerizable unsaturated bonds or by copolymerizing the above monomer with another polymerizable monomer Examples of the polymerizable monomer having a phenolic hydroxyl group include acrylamides, methacrylamides, acrylates, methacrylates and hydroxystyrene which contain a phenolic hydroxyl group. Specific examples of compounds which may be preferably used as the polymerizable monomer include N-(2-hydroxyphenyl)acrylamide, N-(3-hydroxyphenyl)acrylamide, N-(4-hydroxyphenyl)acrylamide, N-(2-hydroxyphenyl)methacrylamide, N-(3-hydroxyphenyl)methacrylamide, N-(4-hydroxyphenyl)methacrylamide, o-hydroxyphenylacrylate, m-hydroxyphenylacrylate, p-hydroxyphenylacrylate, o-hydroxyphenylmethacrylate, m-hydroxyphenylmethacrylate, p-hydroxyphenylmethacrylate, o-hydroxystyrene, m-hydroxystyrene, p-hydroxystyrene, 2-(2-hydroxyphenyl)ethylacrylate, 2-(3-hydroxyphenyl)ethylacrylate, 2-(4-hydroxyphenyl)ethylacrylate, 2-(2-hydroxyphenyl)ethylacrylate, 2-(3-hydroxyphenyl)ethylmethacrylate and 2-(4-hydroxyphenyl)ethylmethacrylate.

These resins having a phenolic hydroxyl group may be used either singly or in combinations of two or more.

A polymer compound having the above (a-2) sulfonamide group may be a polymer compound obtained either by homopolymerizing a polymerizable monomer having a sulfonamide group or by copolymerizing the above monomer with another polymerizable monomer. Given as examples of the polymerizable monomer having a sulfonamide group are polymerizable monomers including a low molecular weight compound having one or more sulfonamide groups -NH - $SO_2$ - in which at least one hydrogen atom is bonded to a nitrogen atom, and one or more polymerizable unsaturated bonds. Among these polymerizable monomers, low molecular weight compounds having an acryloyl group, allyl group or vinyloxy group and a substituted or monosubstituted aminosulfonyl group or substituted sulfonylimino group are preferable.

Given as examples of such compounds are compounds represented by the following formulae (a) to (e), which, however, are not intended to limit the present invention.

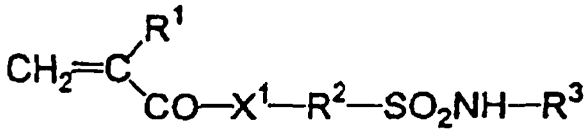

Formula (a)

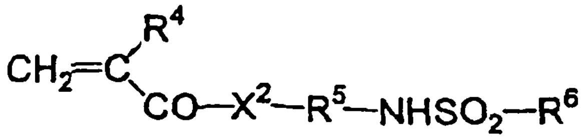

Formula (b)

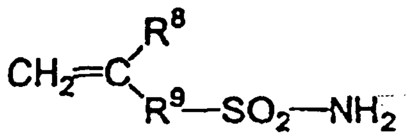

Formula (c)

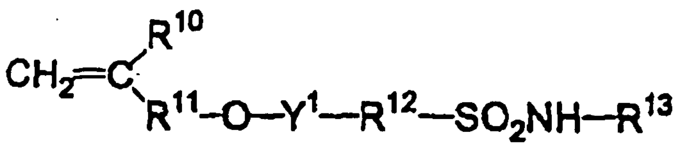

Formula (d)

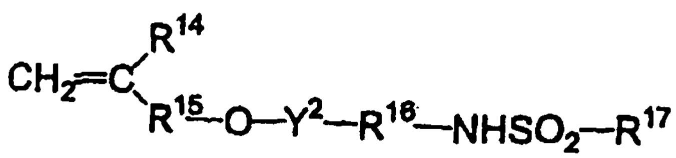

Formula (e)

wherein $X^1$ and $X^2$ respectively represent an oxygen atom or $NR^7$; $R^1$ and $R^4$ respectively represent a hydrogen atom

or $CH_3$; $R^2$, $R^5$, $R^9$, $R^{12}$ and $R^{16}$ respectively represent an alkylene group, a cycloalkylene group, an arylene group or an aralkylene group, which respectively have 1 to 12 carbon atoms and may have a substituent; $R^3$, $R^7$ and $R^{13}$ respectively represent a hydrogen atom or an alkyl group, a cycloalkyl group, an aryl group or an aralkyl group, which respectively have 1 to 12 carbon atoms and may have a substituent; $R^6$ and $R^{17}$ respectively represent an alkyl group, a cycloalkyl group, an aryl group or an aralkyl group, which respectively have 1 to 12 carbon atoms and may have a substituent; $R^8$, $R^{10}$ and $R^{14}$ respectively represent a hydrogen atom or $CH_3$; $R^{11}$ and $R^{15}$ respectively represent an alkylene group, a cycloalkylene group, an arylene group or an aralkylene group, which respectively have 1 to 12 carbon atoms and may have a single bond or a substituent; and $Y^1$ and $Y^2$ respectively represent a single bond or CO.

Among these compounds, m-aminosulfonylphenylmethacrylate, N-(p-aminosulfonylphenyl)methacrylamide and N-(p-aminosulfonylphenyl)acrylamide may be preferably used.

Polymer compounds having the (a-3) active imide group are those having an active imide group represented by the following formula within a molecule. Examples of the polymer compound include polymer compounds obtained either by homopolymerizing a polymerizable monomer comprising a low molecular weight compound that has one or more active imino groups and one or more polymerizable unsaturated bonds, or by copolymerizing the polymerizable monomer with another polymerizable monomer.

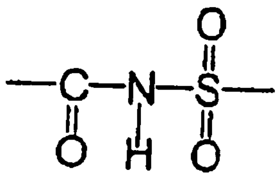

As such a compound, specifically, N-(p-toluenesulfonyl)methacrylamide, N-(p-toluenesulfonyl)acrylamide or the like is preferably used.

As the other alkali-soluble resin, polymer compounds obtained by polymerizing two or more types among the aforementioned polymerizable monomers having a phenolic hydroxyl group, polymerizable monomers having a sulfonamide group and polymerizable monomers having an active imide group and polymer compounds obtained by copolymerizing two or more of these polymerizable monomers with another polymerizable monomer may be used.

In the case of copolymerizing a polymerizable monomer having a phenolic hydroxyl group with a polymerizable monomer having a sulfonamide group and/or a polymerizable monomer having an active imide group, the ratio of these components to be compounded is in a range preferably from 50:50 to 5:95 and particularly preferably from 40:60 to 10:90.

If the other alkali-soluble resin is a copolymer of the aforementioned polymerizable monomers having a phenolic hydroxyl group, polymerizable monomers having a sulfonamide group and polymerizable monomers having an active imide group, the copolymer preferably contains a monomer which affords alkali-solubility in an amount of 10 mol% or more and the copolymer more preferably contains such a monomer in an amount of 20 mol% or more. If the amount of the copolymer component is less than 10 mol%, only insufficient alkali-solubility tends to be obtained, and there may be cases where the effect of improving the developing latitude is insufficiently produced.

As the monomer component to be copolymerized with the aforementioned polymerizable monomer having a phenolic hydroxyl group, polymerizable monomer having a sulfonamide group or polymerizable monomer having an active imide group, for example, monomers given in the following (1) to (12) may be used. However, the present invention is not limited to these monomers.

(1) Acrylates and methacrylates having an aliphatic hydroxyl group such as 2-hydroxyethylacrylate or 2-hydroxyethylmethacrylate.

(2) Alkylacrylates such as methylacrylate, ethylacrylate, propylacrylate, butylacrylate, amylacrylate, hexylacrylate, octylacrylate, benzylacrylate, 2-chloroethylacrylate, glycidylacrylate and N-dimethylaminoethylacrylate.

(3) Alkylmethacrylates such as methylmethacrylate, ethylmethacrylate, propylmethacrylate, butylmethacrylate, amylmethacrylate, hexylmethacrylate, cyclohexylmethacrylate, benzylmethacrylate, 2-chloroethylmethacrylate, glycidylmethacrylate and N-dimethylaminoethylmethacrylate.

(4) Acrylamides or methacrylamides such as acrylamide, methacrylamide, N-methylolacrylamide, N-ethylacrylamide, N-hexylmethacrylamide, N-cyclohexylacrylamide, N-hydroxyethylacrylamide, N-phenylacrylamide, N-nitrophenylacrylamide and N-ethyl-N-phenylacrylamide.

(5) Vinyl ethers such as ethyl vinyl ether, 2-chloroethyl vinyl ether, hydroxyethyl vinyl ether, propyl vinyl ether, butyl vinyl ether, octyl vinyl ether and phenyl vinyl ether.

(6) Vinyl esters such as vinyl acetate, vinyl chloroacetate, vinyl butyrate and vinyl benzoate.

(7) Styrenes such as styrene, $\alpha$-methylstyrene, methylstyrene and chloromethylstyrene.

(8) Vinyl ketones such as methyl vinyl ketone, ethyl vinyl ketone, propyl vinyl ketone and phenyl vinyl ketone.
(9) Olefins such as ethylene, propylene, isobutylene, butadiene and isoprene.
(10) N-vinylpyrrolidone, N-vinylcarbazole, 4-vinylpyridine, acrylonitrile and methacrylonitrile.
(11) Unsaturated imides such as maleimide, N-acryloylacrylamide, N-acetylmethacrylamide, N-propionylmethacrylamide and N- (p-chlorobenzoyl)methacrylamide.
(12) Unsaturated carboxylic acids such as acrylic acid, methacrylic acid, maleic acid anhydride and itaconic acid.

If the other alkali-soluble resin is a homopolymer or copolymer of the aforementioned polymerizable monomer having a phenolic hydroxyl group, polymerizable monomer having a sulfonamide group or polymerizable monomer having an active imide group, a homopolymer or copolymer having a weight average molecular weight of 2,000 or more and a number average molecular weight of 500 or more is preferable. Homopolymers or copolymers having a weight average molecular weight of 5,000 to 300,000, a number average molecular weight of 800 to 250,000 and a degree of dispersion (weight average molecular weight/number average molecular weight) of 1.1 to 10 are more preferable.
These other alkali-soluble resins may be used singly or in combinations of two or more. The ratio of the alkali-soluble resin to the recurring xylenol unit-containing novolac resin according to the present invention is preferably 0.05/1 to 1/0.1 and more preferably 0.1/1 to 1/0.2.

*Materials which absorb light and generate heat*

In the present invention, a pigment or dye is added as a material which absorbs light and generates heat.
As a pigment, commercially available pigments and pigments described in Color Index (C.I.) Handbook, "Latest Pigment Handbook" (edited by Japan Pigment Technological Association, published in 1977), "Latest Pigment Applied Technology" (CMC Shuppan, published in 1986) and "Printing Ink Technology" (CMC Shuppan, published in 1984) may be utilized.
Examples of the type of pigment include black pigments, yellow pigments, orange pigments, brown pigments, red pigments, violet pigments, blue pigments, green pigments, fluorescent pigments, metal powder pigments and other polymer-bound dyes. Specific examples of pigments which may be used in the present invention include insoluble azo pigments, azo lake pigments, condensed azo pigments, chelate azo pigments, phthalocyanine type pigments, anthraquinone type pigments, perillene and perinone type pigments, thioindigo type pigments, quinacridone type pigments, dioxazine type pigments, isoindolinone type pigments, quinophthalone type pigments, dyeing lake pigments, azine pigments, nitroso pigments, nitro pigments, natural pigments, fluorescent pigments, inorganic pigments, carbon black and the like.
Each of these pigments may be used either without carrying out a surface treatment thereon or after a surface treatment. As a surface-treating method, it is possible to use a method in which the surface is coated with a resin or wax, a method in which a surfactant is allowed to adhere to the surface or a method in which a reactive material (e.g., silane coupling agents, epoxy compounds and polyisocyanates) is bound to the surface of the pigment. The aforementioned surface treating methods are described in "Qualities and Applications of Metal Soaps" (Saiwai Shobou), "Printing Ink Technology" (CMC Shuppan, published in 1984) and "Latest Pigment Applied Technology" (CMC Shuppan, published in 1986).
The particle diameter of the pigment is in a range preferably from 0.01 μm to 10 μm, more preferably from 0.05 μm to 1 μm and particularly preferably 0.1 μm to 1 μm. It is undesirable if the particle diameter of the pigment is less than 0.01 μm in view of stability of dispersion in the light-sensitive layer coating solution, and it is undesirable if the particle diameter exceeds 10 μm in view of uniformity of the light-sensitive layer.
As a method of dispersing the pigment, known dispersing techniques that are used in the manufacturing of ink or the production of toner may be used. Examples of a dispersing machine include an ultrasonic dispersing machine, sand mill, attritor, pearl mill, super mill, ball mill, impeller, disperser, KD mill, colloid mill, dynatron, three-roll mill and pressure kneader. The details are described in "Latest Pigment Applied Technology" (CMC Shuppan, published in 1986).
As the dye, commercially available dyes and known dyes described in the literature (e.g., "Dye Handbook", edited by Organic Synthetic Chemical Association, published in 1970) may be utilized. Specific examples of the dye include azo dyes, metal complex salt azo dyes, pyrazolone azo dyes, anthraquinone dyes, phthalocyanine dyes, carbonium dyes, quinoneimine dyes, methine dyes and cyanine dyes.
In the present invention, among these pigments and dyes, those that absorb infrared light or near-infrared light are particularly preferable in view of adaptability for use with a laser which emits infrared light or near-infrared light.
Carbon black can be preferably used as such a pigment which absorbs infrared light or near-infrared light. Examples of dyes which absorb infrared light or near-infrared light include cyanine dyes described in JP-A Nos. 58-125246, 59-84356, 59-202829, 60-78787 and the like, methine dyes described in JP-A Nos. 58-173696, 58-181690, 58-194595 and the like, naphthoquinone dyes described in JP-A Nos. 58-112793, 58-224793, 59-48187, 59-73996, 60-52940, 60-63744 and the like, squarylium dyes described in JP-A No. 58-112792, cyanine dyes described in U.K. Patent No. 434,875 and dihydroperimidinesquarylium dyes described in U.S. Patent No. 5,380,635.

Also, near-infrared absorption sensitizing agents described in U.S. Patent No. 5,156,938 can be preferably used as the dye. Substituted arylbenzo(thio)pyrylium salts described in U.S. Patent No. 3,881,924, trimethinethiapyrylium salts described in JP-A No. 57-142645 (U.S. Patent No. 4,327,169), pyrylium type compounds described in JP-A Nos. 58-181051, 58-220143, 59-41363, 59-84248, 59-84249, 59-146063 and 59-146061, cyanine dyes described in JP-A No. 59-216146, pentamethinethiopyrylium salts described in U.S. Patent No. 4,283,475 and pyrylium compounds disclosed in the publications of JP-B Nos. 5-13514 and 5-19702 and, as commercially available products, Epolight III-178, Epolight III-130, Epolight III-125 and Epolight IV-62A (manufactured by Epolin) are used particularly preferably.

Also, particularly preferable examples of the dye may include near-infrared absorbing dyes represented by the formulae (I) and (II) in the specification of U.S. Patent No. 4,756,993.

Each of these pigments or dyes may be added in an amount of 0.01 to 50% by weight and preferably 0.1 to 10% by weight, and particularly preferably 0.5 to 10% by weight in the case of the dye and 1 to 10% by weight in the case of the pigment, with respect to total solids of the image-forming composition which forms the light-sensitive layer. If the amount of the pigment or dye to be added is less than 0.01% by weight, the sensitivity will be low, whereas if the amount exceeds 50% by weight, the uniformity of the resulting light-sensitive layer will be lost and the durability of the light-sensitive layer will be impaired.

Each of these dyes or pigments may be added to the same layer as other components. Alternatively, a separate layer may be formed and each of these dyes or pigments added to the separate layer. In the case of adding to the separate layer, the dye or the pigment is desirably added to a layer adjacent to the layer containing the material which substantially decreases the solubility of the binding agent, which is heat-decomposable as explained later, provided that the binding agent is not decomposed.

*Other components*

Various additives may be further added to the image-forming composition used to form the light-sensitive layer in the present invention as necessary. It is desirable to jointly use materials, such as onium salts, aromatic sulfone compounds and aromatic sulfonate compounds, which are heat-decomposable and substantially lower the solubility of the alkali-soluble polymer compound, provided that it is not decomposed, in view of improving resistance to dissolution in a developing solution of an image portion.

Examples of the onium salt may include diazonium salts, ammonium salts, phosphonium salts, iodonium salts, sulfonium salts, selenonium salts and arsonium salts.

Preferable examples of the onium salt used in the present invention include diazonium salts described in S.I. Schlesinger, Photogr. Sci. Eng., 18, 387 (1974), T.S. Bal et al., Polymer, 21, 423 (1980) and the publication of JP-A No. 5-158230; ammonium salts described in the specifications of U.S. Patent Nos. 4, 069, 055 and 4, 069, 056 and JP-A No. 3-140140; phosphonium salts described in D.C. Necker et al., Macromolecules, 17, 2468 (1984), C.S. Wen et al., Teh, Proc. Conf. Rad. Curing ASIA, p478 Tokyo, Oct (1988) and U.S. Patent Nos. 4,069,055 and 4,069,056; iodonium salts described in J.V. Crivello et al., Macromolecules, 10(6), 1307 (1977), Chem. & Eng. News, Nov. 28, p31 (1988), European Patent No. 104,143, U.S. Patent Nos. 4,339,049 and 4,410,201, JP-A Nos. 2-150848 and 2-296514, sulfonium salts described in J.V. Crivello et al., Polymer J. 17, 73 (1985), J.V. Crivello et al., J. Org. Chem., 43, 3055 (1978), W.R. Watt et al., J. Polymer Sci., Polymer Chem. Ed., 22, 1789 (1984), J.V. Crivello et al., Polymer Bull., 14, 279 (1985), J.V. Crivello et al, Macromolecules, 14 (5), 1141 (1981), J.V. Crivello et al., J. Polymer Sci., Polymer Chem. Ed., 17, 2877 (1979), European Patent Nos. 370,693, 233,567, 297,443 and 297,442, U.S. Patent Nos. 4,933,377, 3,902,114, 4,410,201, 4,339,049, 4,760,013, 4,734,444 and 2,833,827, German Patent Nos. 2,904,626, 3,604,580 and 3,604,581, selenium salts described in J.V. Crivello et al. , Macromolecules, 10(6), 1307 (1977), J.V. Crivello et al., J. Polymer Sci., Polymer Chem. Ed., 17, 1047 (1979) and arsonium salts described in C.S. Wen et al., Teh, Proc. Conf. Rad. Curing ASIA, p478 Tokyo, Oct (1988).

Examples of a counter ion of the onium salt may include tetrafluoroborate, hexafluorophosphate, triisopropylnaphthalenesulfonic acid, 5-nitro-o-toluenesulfonic acid, 5-sulfosalicylic acid, 2,5-dimethylbenzenesulfonic acid, 2,4,6-trimethylbenzenesulfonic acid, 2-nitrobenzenesulfonic acid, 3-chlorobenzenesulfonic acid, 3-bromobenzenesulfonic acid, 2-fluorocaprylnaphthalenesulfonic acid, dodecylbenzenesulfonic acid, 1-naphthol-5-sulfonic acid, 2-methoxy-4-hydroxy-5-benzoyl-benzenesulfonic acid, paratoluenesulfonic acid and the like. Among these compounds, particularly hexafluorophosphoric acid and alkyl aromatic sulfonic acids such as triisopropylnaphthalenesulfonic acid and 2,5-dimethylbenzenesulfonic acid are desirable.

The amount of the additive onium salt compounded is preferably 1 to 50% by weight, more preferably 5 to 30% by weight and particularly preferably 10 to 30% by weight in the total solids of the image-forming composition.

In the present invention, these additives and the binder are preferably contained in the same layer.

Also, cyclic acid anhydrides, phenols and organic acids may be used together for the purpose of improving sensitivity. As the cyclic acid anhydride, phthalic acid anhydride, tetrahydrophthalic acid anhydride, hexahydrophthalic acid anhydride, 3,6-endoxy-Δ4-tetrahydrophthalic acid anhydride, tetrachlorophthalic acid anhydride, maleic acid anhydride, chloromaleic acid anhydride, α-phenylmaleic acid anhydride, succinic acid anhydride and pyromellitic acid anhydride as described in the specification of U.S. Patent No. 4,115,128 may be used. Examples of the phenols include bisphenol A, p-nitrophenol, p-ethoxyphenol, 2,4,4'-trihydroxybenzophenone, 2,3,4-trihydroxybenzophenone, 4-hydroxybenzophenone, 4,4',4"-trihydroxytriphenylmethane and 4,4',3",4"-tetrahydroxy-3,5,3',5'-tetramethyltriphenylmetha ne. Examples of the organic acids include sulfonic acids, sulfinic acids, alkyl sulfates, phosphonic acids, phosphates and carboxylic acids as described in, for example, the publications of JP-A Nos. 60-88942 and 2-96755. Given as specific examples of the organic acids are p-toluenesulfonic acid, dodecylbenzenesulfonic acid, p-toluenesulfinic acid, ethylsulfuric acid, phenylphosphonic acid, phenylphosphinic acid, phenyl phosphate, diphenyl phosphate, benzoic acid, isophthalic acid, adipic acid, p-toluic acid, 3,4-dimethoxybenzoic acid, phthalic acid, terephthalic acid, 4-cyclohexene-1,2-dicarboxylicacid, erucic acid, lauricacid, n-undecanoic acid and ascorbic acid.

The proportion of the aforementioned cyclic acid anhydride, phenols and organic acids in the total solid of the image-forming composition is preferably 0.05 to 20% by weight, more preferably 0.1 to 15% by weight and particularly preferably 0.1 to 10% by weight.

A nonionic surfactant as described in the publications of JP-A Nos. 62-251740 and 3-208514 and an amphoteric surfactant as described in the publications of JP-A Nos. 59-121044 and 4-13149 may be added to the image-forming composition according to the present invention to widen the range of stability to developing conditions.

Specific examples of the nonionic surfactant include sorbitan tristearate, sorbitan monopalmitate, sorbitan trioleate, monoglyceride stearate and polyoxyethylenenonyl phenyl ether.

Specific examples of the amphoteric surfactant include alkyldi(aminoethyl)glycine, alkylpolyaminoethylglycine hydrochloride, 2-alkyl-N-carboxyethyl-N-hydroxyethylimidazolinium betaine and N-tetradecyl-N,N-betaine (e.g., trademark: "Amorgen K", manufactured by Dai-Ichi Kogyo).

The proportion of the above nonionic surfactant and amphoteric surfactant in the image-forming composition is preferably 0.05 to 15% by weight and more preferably 0.1 to 5% by weight.

A printing-out agent, used to obtain a visible image directly after heat-treatment by exposure, and dyes or pigments used as image colorants may be added to the image-forming composition of the present invention.

Given as typical examples of the printing-out agent are combinations of a compound which releases an acid when heated in exposure (optically acid-releasable agent) and an organic dye capable of producing a salt. Specific examples of these combinations include combinations of o-naphthoquinonediazide-4-sulfonic acid halogenide and a salt-formable organic dye as described in the publications of JP-A Nos. 50-36209 and 53-8128 and combinations of a trihalomethyl compound and a salt-formable organic dye as described in the publications of JP-A Nos. 53-36223, 54-74728, 60-3626, 61-143748, 61-151644 and 63-58440. Such trihalomethyl compounds include oxazole type compounds and triazine type compounds, which have high aging stability and provide a clear print-out image.

As the image-colorant, other dyes may be used in addition to the aforementioned salt-formable organic dyes. Preferable dyes may include oil-soluble dyes and basic dyes, including the salt-formable organic dyes. Specific examples may include Oil Yellow #101, Oil Yellow #103, Oil Pink #312, Oil Green BG, Oil Blue BOS, Oil Blue #603, Oil Black BY, Oil Black BS and Oil Black T-505 (manufactured by Orient Kagaku Kogyo), Victoria Pure Blue, Crystal Violet (CI42555), Methyl Violet (CI42535), Ethyl Violet, Rhodamine B (CI145170B), Malachite Green (CI42000) and Methylene Blue (CI52015). Also, dyes described in the publication of JP-A No. 62-293247 are particularly preferable. These dyes may be added in a proportion of 0.01 to 10% by weight and more preferably 0.1 to 3% by weight in the total solids of the image-forming composition.

A plasticizer may be added as required to the image-forming composition of the present invention, to impart softness and the like of a coating film. For example, butylphthalyl, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate, oligomers or polymers of acrylic acid or methacrylic acid, and the like may be used.

The image-forming composition is formed by dissolving each above component of the composition in a solvent to form a coating solution. The solution is applied to an appropriate support. The positive planographic printing plate of the present invention can be produced by forming the light-sensitive layer in this manner. Examples of the solvent to be used here may include, but are not limited to, ethylene dichloride, cyclohexanone, methyl ethyl ketone, methanol, ethanol, propanol, ethylene glycol monomethyl ether, 1-methoxy-2-propanol, 2-methoxyethyl acetate,

1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone and toluene. These solvents may be used either singly or as mixtures. The concentration of the above component (total solid including additives) in the coating solution is preferably 1 to 50% by weight. The amount (solid content) of the coating solution applied to the support, after the coating solution is applied and dried, is generally preferably 0.5 to 5.0 $g/m^2$ in the case of a positive planographic printing master plate, though this may vary depending on use. As a coating method, various methods may be used. Examples of these methods may include bar coater coating, rotating coating, spray coating, curtain coating, dip coating, air-knife coating, blade coating and roll coating. With a decreased coating amount, apparent sensitivity will be increased but the film characteristics of the light-sensitive layer will be low.

A surfactant such as a fluorine type surfactant as described in JP-A No. 62-170950 may be added to the image-forming composition of the present invention to improve coatability. The amount to be added is preferably 0.01 to 1% by weight and more preferably 0.05 to 0.5% by weight in the total solid of the light-sensitive layer.

Examples of the support to be used in the present invention include dimensionally stable plate materials such as paper, paper on which a plastic (e.g., polyethylene, polypropylene or polystyrene) is laminated, metal plates (e.g., aluminum, zinc and copper), plastic films (e.g., cellulose diacetate, cellulose triacetate, cellulosepropionate, cellulosebutylate, cellulose acetate butylate, cellulose nitrate, polyethylene terephthalate, polyethylene, polystyrene, polypropylene, polycarbonate and polyvinylacetal) and paper on which a metal as aforementioned is laminated or deposited, plastic films and the like.

As the support in the present invention, polyester films or aluminum plates are desirable. Among these materials, aluminum plates, which are dimensionally stable and relatively inexpensive, are particularly preferable. Preferable aluminum plates are pure aluminum plates and alloy plates having aluminum as their major component and containing minute amounts of foreign elements, and may be plastic films on which aluminum is laminated or deposited. The foreign elements contained in an aluminum alloy may include silicon, iron, manganese, copper, magnesium, chromium, zinc, bismuth, nickel and titanium. The content of the foreign elements is a maximum of 10% by weight. Aluminum which is particularly preferable as the support in the present invention is pure aluminum. However, it is difficult to obtain perfectly pure aluminum because of difficulties in refining techniques, and therefore aluminum containing minute amounts of foreign elements is acceptable. The composition of an aluminum plate to be applied as the support in the present invention in this manner is not specified, and conventionally known and commonly used aluminum plate materials may be used. The thickness of the aluminum plate used for the support in the present invention is about 0.1 mm to 0.6 mm, preferably 0.15 mm to 0.4 mm and particularly preferably 0.2 mm to 0.3 mm.

A degreasing treatment of the aluminum plate by using, for example, a surfactant, an organic solvent or an aqueous alkaline solution is performed to remove rolling oil from the surface prior to roughing of the aluminum plate, as necessary.

The treatment of roughing the surface of the aluminum plate may be carried out using various methods, such as a method of roughing mechanically, a method of roughing by dissolving the surface electrochemically and a method of selectively dissolving the surface chemically. As the mechanical method, known methods such as a ball polishing method, brush polishing method, blast polishing method and buff polishing method may be used. On the other hand, as the electrochemical roughing method, there is a method in which the treatment is performed in a hydrochloric acid or nitric acid electrolyte using a.c. or d.c. current. Also, a combination of the above two kinds of method may be used, as disclosed in JP-A No. 54-63902.

The aluminum plate roughened in this manner is subjected to an alkali etching treatment and a neutralization treatment and thereafter to an anodic oxidation treatment to improve water-retentivity and wear resistance of the surface, as desired. As the electrolyte used for the anodic oxidation treatment of the aluminum plate, various electrolytes for forming a porous oxide film may be used and sulfuric acid, phosphoric acid, oxalic acid, chromic acid or mixed acids of these acids may usually be used. The density of each of these electrolytes is suitably determined according to the type of electrolyte.

The conditions of the anodic oxidation treatment vary depending upon the type of electrolyte and are not therefore specified in a general manner. However, each condition is preferably in the following ranges: concentration of the electrolyte, 1 to 80% by weight solution; liquid temperature, 5 to 70°C; current density, 5 to 60 A/dm$^2$; voltage, 1 to 100 V; and electrolysis time, 10 seconds to 5 minutes.

If the amount of the anodic oxide film is smaller than 1.0 g/m$^2$, only insufficient printing durability is obtained and the non-image portion is easily flawed, which easily causes the so-called "flaw stains", specifically, ink is stuck to a flawed part during printing.

After the anodic oxidation treatment is performed, the surface of aluminum is subjected to hydrophilic treatment, as necessary. The hydrophilic treatment used in the present invention includes an alkali metal silicate (for example, an aqueous sodium silicate solution) method as disclosed in U.S. Patent Nos. 2,714,066, 3,181,461, 3,280,734 and 3,902,734 . In this method, the support is treated by dipping in an aqueous sodium silicate solution, or treated electrolytically. Besides the above methods, for instance, a method of treating using potassium fluorozirconate as disclosed in JP-B No. 36-22063 or a method of treating using polyvinylphosphonic acid as disclosed in U.S. Patent Nos. 3,276,868, 4,153,461 and 4,689,272 can be used.

The positive planographic printing master plate of the present invention is a type in which a positive light-sensitive image-forming layer is formed on a support. An undercoat layer may be formed between the support and the image-forming layer as necessary.

As a component of the undercoat layer, various organic compounds can be used. The component may be selected from carboxymethyl cellulose, dextrin, gum arabic, phosphonic acids having an amino group such as 2-aminoethylphosphonic acid, organic phosphonic acids, which may have substituents, such as phenylphosphonic acid, naphthylphosphonic acid, alkylphosphonic acid, glycerophosphonic acid, methylenediphosphonic acid and ethylenediphosphonic acid, organic phosphoric acids, which may have substituents such as phenylphosphoric acid, naphthylphosphoric acid, alkylphosphoric acid and glycerophosphoric acid, organic phosphinic acids, which may have substituents, such as phenylphosphinic acid, naphthylphosphinic acid, alkylphosphinic acid and glycerophosphinic acid, amino acids such as glycine and β-alanine and hydrochlorides of amines having a hydroxyl group such as hydrochloride of triethanolamine. These organic compounds may be used as mixtures thereof.

This organic undercoat layer may be provided by the following method. Specifically, it is possible to adopt a method in which a solution, prepared by dissolving the above organic compound in water, an organic solvent such as methanol, ethanol or methyl ethyl ketone or a mixed solvent of these solvents, is applied to an aluminum plate and dried or a method in which an aluminum plate is dipped in a solution, prepared by dissolving the above organic compound in water, an organic solvent such as methanol, ethanol and methyl ethyl ketone or a mixed solvent of these solvents, to allow the above compound to adhere to the support, and thereafter the support is washed with water or the like and dried to form the organic undercoat layer. In the former method, a solution in which the concentration of the above organic compound is 0.005 to 10% by weight may be applied using various methods. In the latter method, the concentration of the solution is 0.01 to 20% by weight and preferably 0.05 to 5% by weight, the dipping temperature is 20 to 90°C and preferably 25 to 50°C and the dipping time is 0.1 seconds to 20 minutes and preferably 2 seconds to 1 minute. The solution used for this purpose can be adjusted to a pH ranging from 1 to 12 by using a basic material such as ammonia, triethylamine or potassium hydroxide or an acidic material such as hydrochloric acid or phosphoric acid. Also, a yellow dye may be added to improve the tone reproducibility of the image-forming layer.

The amount of the organic undercoat layer to be applied is appropriately 2 to 200 $mg/m^2$ and preferably 5 to 100 $mg/m^2$. If the above coating amount is smaller than 2 $mg/m^2$, sufficient printing durability cannot be obtained, and if the amount is greater than 200 $mg/m^2$, the same result will occur.

The positive planographic printing plate manufactured in the above manner is usually subjected to image exposure and developing treatment.

As a light source of active rays to be used for the image exposure, light sources having an emission wavelength in the near-infrared to infrared region are preferable and a solid laser or a semiconductor laser is particularly preferable.

As the developing solution or replenishing solution used for the positive printing master plate of the present invention, conventionally known aqueous alkali solutions may be used. Given as examples of the aqueous alkali solution are solutions of inorganic alkali salts such as sodium silicate, potassium silicate, sodium tertiary phosphate, potassium tertiary phosphate, ammonium tertiary phosphate, sodium secondary phosphate, potassium secondary phosphate, ammonium secondary phosphate, sodium carbonate, potassium carbonate, ammonium carbonate, sodium bicarbonate, potassium bicarbonate, ammonium bicarbonate, sodium borate, potassium borate, ammonium borate, sodium hydroxide, ammonium hydroxide, potassium hydroxide and lithium hydroxide. Also, organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine and pyridine.

These alkaline agents may be used either singly or in combinations of two or more.

A particularly preferable developing agent among these alkaline agents is an aqueous solution of a silicate such as sodium silicate or potassium silicate. This is because developing ability can be controlled by the ratio and concentrations of silicon oxide ($SiO_2$) which is the silicate component and an alkali metal oxide ($M_2O$). For example, alkali metal silicates as described in the publications of JP-A No. 54-62004 and JP-B No. 57-7427 are effectively used.

It is known that when a developing operation is carried out using an automatic developing machine, a large number of planographic printing plates can be treated without exchanging a developing solution contained in a developing solution tank over a long period of time, by addition of an aqueous solution (replenishing solution) having higher alkalinity than the developing solution. In the present invention, this replenishing system is also preferably applied. Various surfactants and organic solvents may be added as required to the developing solution and the replenishing solution for purposes of promoting or suppressing developing ability, improving the dispersion of wastes produced by developing, and improving the affinity of the image portion of the printing plate to ink. Preferable examples of the surfactant include an anionic type, cationic type, nonionic type and amphoteric type.

A reducing agent, such as a sodium salt of an inorganic acid such as hydroquinone, resorcinol, sulfurous acid, hydrogen sulfuric acid, and further an organic carboxylic acid, an anti-foaming agent and a water softener may be added to the developing solution and replenishing solution as necessary.

The planographic printing plate which is developed using the above developing solution and replenishing solution is after-treated using a rinse solution containing washing water, a surfactant and the like, and an insensitization-greasing solution containing gum arabic and a starch derivative. As after-treatment in the case of using the image-forming composition of the present invention for a printing plate, these treatments

may be used in combination.

In plate-making and printing fields in recent years, an automatic developing machine for printing plates has been widely used for rationalization and standardization of plate-making works. This automatic developing machine

usually consists of a developing section and an after-treatment section, including a system for conveying a planographic printing plate, respective process solution vessels and a spray system. In the developing machine, each process solution drawn by a pump is sprayed from a spray nozzle while an exposed printing plate is carried horizontally to carry out developing. Also, a method is known today in which a planographic printing plate is dipped and conveyed in a process solution vessel filled with a process solution by using, for example, a submerged guide roll. In such an automatic process, the printing plate may be treated while a replenishing solution is supplied to each process solution in response to throughput and operating time.

Also, a so-called nonreturnable treating system using a substantially unused process solution to carry out treatment can be applied.

If unnecessary image portions (e.g., a film edge mark of an original image film) are present on the planographic printing plate after image exposure, developing, washing with water and/or rinsing and/or gum-drawing are carried out, measures may be taken to erase the unnecessary image portions. As the above erasing method, a method in which an erasing liquid is applied to the unnecessary image portion and is allowed to stand as is for a fixed time, followed by washing with water as described in the publication of JP-B No. 2-13293 is preferable. However, a method in which active light rays guided by an optical fiber are applied to the unnecessary image portion, followed by developing as described in the publication of JP-A No. 59-174842 may also be utilized.

The planographic printing plate obtained in the above manner may be subjected to a printing step after an insensitization-greasing gum is applied as desired to the printing plate. A burning treatment may be performed for the purpose of making the planographic printing plate have more improved printing durability.

If the planographic printing plate is treated by burning, it is preferable to treat the planographic printing plate by using a surface regulating solution prior to the burning, as described in the publication of each of JP-B Nos. 61-2518, and 55-28062, and JP-A Nos. 62-31859 and 61-159655.

As the treating method, a method in which the surface regulating solution is applied to the surface of the printing plate using a sponge or absorbent cotton impregnated with the surface regulating solution, a method in which the planographic printing plate is immersed in a butt filled with the surface regulating solution to apply the solution to the planographic printing plate and a method of applying using an automatic coater may be used. Also, it is more preferable to make the applied amount uniform with a squeegee or a squeegee roller after the application is finished.

The amount of the surface regulating solution to be applied is appropriately 0.03 to 0.8 $g/m^2$ (dry weight).

The planographic printing plate coated with the surface regulating solution is dried and then heated to high temperatures by using a burning processor (e.g., Burning Processor: Product name "BP-1300") marketed by Fuji Photo Film Co., Ltd. Heating temperature and time in this case are preferably in a range from 180 to 300°C and in a range from 1 to 20 minutes respectively, though these conditions will differ depending upon the types of component for forming an image.

The planographic printing plate which has been treated by burning may be subjected appropriately to treatments which are conventionally performed such as washing and gum-drawing as necessary. In cases where a surface regulating solution containing an aqueous polymer compound and the like is used, the so-called insensitization-greasing treatment, such as gum-drawing, can be omitted.

The planographic printing plate obtained by the aforementioned treatments is incorporated into an offset printer and used to print a number of sheets.

## EXAMPLES

The present invention will be hereinafter explained in detail by way of examples, which, however, are not intended to be limiting of the present invention.

### Examples 1 to 5, Comparative Example 1

*Production of a planographic printing plate*

A 0.3-mm-thick aluminum plate was washed with trichloroethylene to degrease. Then the surface of the aluminum plate was pebbled using a nylon brush and a 400 mesh pumice/water suspension and was then thoroughly washed with water. This plate was immersed in an aqueous 25% sodium hydroxide solution at 45°C for 9 seconds to carry out etching, followed by washing with water. The plate was further immersed in a 20% nitric acid solution for 20 seconds and then washed. At this time, the amount of etching of the pebbled surface was about 3 $g/m^2$. Next, the plate was formed with a 3 $g/m^2$ d.c. anodic oxidation film, using 7% sulfuric acid as an electrolyte at a current density of 15 $A/dm^2$. After that, the plate was washed with water and dried.

The resulting plate was treated in an aqueous solution of 2.5% by weight of sodium silicate at 30°C for 10 seconds and coated with the undercoat solution described below. The film was dried at 80°C for 15 seconds to obtain

a support. The amount of the film applied was 15 mg/$m^2$ after drying.

The coating solution for a light-sensitive layer-forming solution was applied to the resulting support such that the amount applied was 1.5 g/$m^2$, to obtain planographic printing master plates 1 to 6. Planographic printing master plates produced using light-sensitive solutions 1 to 5 containing a recurring xylenol unitcontaining novolac resin were designated as Examples 1 to 5 respectively. Also, a planographic printing master plate produced using a light-sensitive solution 6 containing a known novolac resin was obtained and designated as Comparative Example 1.

The molar ratio between monomers of a novolac resin to be used, the weight average molecular weight of the novolac resin and the amount of unreacted monomers are as follows.

˙ Novolac resin 1
Phenol/m-cresol/2,3-xylenol (50/30/20)
Mw: 7,600, unreacted monomer: 0.8% by weight.
˙ Novolac resin 2
m-Cresol/p-cresol/3,5-xylenol (30/30/40)
Mw: 2,500, unreacted monomer: 0.5% by weight.
˙ Novolac resin 3 Reference-not part of of the invention
m-Cresol/2,5-xylenol (20/80)
Mw: 5,400, unreacted monomer: 0.6% by weight
˙ Novolac resin 4
Phenol/3,5-xylenol (50/50)
Mw: 9,800, unreacted monomer: 1.0% by weight
˙ Novolac resin 5
m-Cresol/2,3-xylenol (90/10)
Mw: 3,300, unreacted monomer: 0.5% by weight
˙ Novolac resin 6
m-cresol/p-cresol (60/40)
Mw: 4,000, unreacted monomer: 0.5% by weight

| Light-sensitive solutions 1 to 5 | |
|---|---|
| ˙ Novolac resin (resin described in Table 1) | 1.0 g |
| ˙ Cyanine dye A (the structure shown below) | 0.1 g |
| ˙ Phthalic acid anhydride | 0.05 g |
| ˙ p-Toluenesulfonic acid | 0.002 g |
| ˙ Ethyl violet in which the counter ion was 6-hydroxy-β-naphthalenesulfonic acid | 0.02 g |
| ˙ Fluorine type surfactant (Product name: Megafac F-177, manufactured by Dainippon Ink and Chemicals) | 0.05 g |
| ˙ Methyl ethyl ketone | 8 g |
| ˙ 1-Methoxy-2-propanol | 4 g |

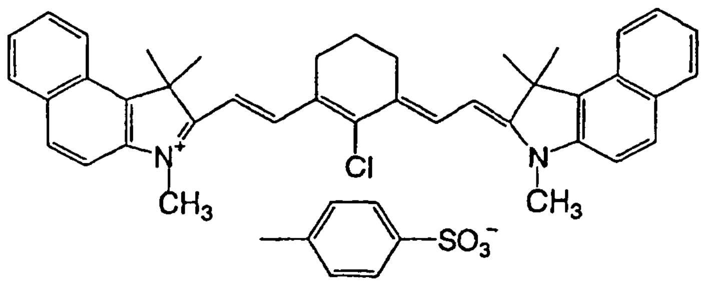

Cyanine dye A

Table 1

| | Planographic printing plate | Light-sensitive solution | Novolac resin |
|---|---|---|---|
| Example 1 | Planographic printing plate 1 | Light-sensitive solution 1 | Novolac resin 1 |
| Example 2 | Planographic printing plate 2 | Lieht-sensitive solution 2 | Novolac resin 2 |
| Example 3* | Planographic* printing plate 3* | Light-sensitive* solution 3 | Novolac resin 3* |
| Example 4 | Planographic printing plate 4 | Light-sensitive solution 4 | Novolac resin 4 |
| Example 5 | Planographic printing plate 5 | Light-sensitive solution 5 | Novolac resin 5 |
| Comparative Example 1 | Planographic printing plate 6 | Light-sensitive solution 6 | Novolac resin 6 |
| *Reference Example-not part of the invention | | | |

*Evaluation of planographic printing master plates*

A part of each planographic printing master plate was packaged with craft paper and allowed to stand for 3 days in a thermostatic chamber at ambient temperature and at 45°C and a humidity of 75%. The aging for 3 days, during which each planographic printing master plate was stored in the thermostatic chamber, ensured that evaluation the same as for aging a planographic printing master plate stored at ambient temperature for a period from about several months to one year could be made. It is to be noted that a reduction in sensitivity when a planographic printing master plate is stored for 3 days at ambient temperature is almost unobservable, in general.

These planographic printing plates were exposed using a Plate Setter Trendsetter 3244F, manufactured by Kureo and developed using an automatic developing machine. As to conditions of exposure, a number of rotations was fixed to 150 rpm and output power was changed in about 9% increments from 3 to 12 W to find clear sensitivity. The clear sensitivity is defined as a minimum energy required to dissolve an exposed portion perfectly, and the quantity of energy (E) is given by the following formula.

$$E = W \times 2350/rpm \text{ (W: output power, rpm: number of rotations)}$$

20 litres of an alkali developing process solution suitable for the respective planographic printing plate, among an alkali developing process solution A (pH: about 13) and an alkali developing process solution B (pH: about 13.2) respectively having the following compositions, was filled into a developing process vessel of a commercially available automatic developing machine LP-900H (manufactured by Fuji Photo Film Co., Ltd.) provided with a dipping-type developing vessel and kept at 30°C. 8 litres of tap water was laid in a second bath of the LP-900H and a finishing gum solution prepared by diluting FP-2W (manufactured by Fuji Photo Film Co., Ltd.) with water (1:1) was laid in a third bath of the LP-900H. The developing treatment of each of the planographic printing master plates 1 to 6 was carried out in the automatic developing machine provided with a developing process solution suitable for the planographic printing plate. The alkali developing process solution used here and the results of evaluation are shown in Table 2 below.

Composition of the alkali developing process solution A

| | |
|---|---|
| · $SiO_2 \cdot K_2O$ ($K_2O/SiO_2$ = 1.1 (mol ratio)) | 4.0% by weight |
| · Citric acid | 0.5% by weight |
| · Polyethylene glycol (weight average molecular weight: 1,000) | 0.5% by weight |
| · Water | 95.0% by weight |

Composition of the alkali developing process solution B:

| | |
|---|---|
| · $SiO_2 \cdot K_2O$ ($K_2O/SiO_2$) - = 1.1 (mol ratio)) | 8.0% by weight |
| · Citric acid | 1.0% by weight |
| · Polyethylene glycol (weight average molecular weight: 1,000) | 1.0% by weight |
| · Water | 90.0% by weight |

Table 2

| | Clear sensitivity (mJ/cm$^2$) | | | |
|---|---|---|---|---|
| | Alkali developing process solution A | | Alkali developing process solution B | |
| | Ambient temperature aging | 45°C, 75% humidity aging | Ambienttemperature aging | 45°C, 75% humidity aging |
| Example 1 | 61 | 67 | - | - |
| Example 2 | 56 | 61 | - | - |
| Example 3* | - | - | 56 | 61 |
| Example 4 | 56 | 61 | - | - |
| Example 5 | 51 | 56 | - | - |
| Comparative Example 1 | 79 | 122 | - | - |
| *Reference Example-not part of the invention | | | | |

As is clear from Table 2, the planographic printing master plates using recurring xylenol unit-containing novolac resins according to the present invention had high sensitivity and excellent stability with time. On the other hand, the Comparative Example provided with a light-sensitive layer having the same structure as the Examples except that a conventionally known novolac resin was used had insufficient storage stability.

Examples 6 to 8 and Comparative Example 2

*Synthesis of copolymer 1*

A 500 ml three-neck flask equipped with a stirrer, a condenser tube and a dropping funnel was charged with 31.0 g (0.36 mol) of methacrylic acid, 39.1 g (0.36 mol) of ethyl chloroformate and 200 ml of acetonitrile and the mixture was stirred while it was cooled in an ice-water bath. 36.4 g (0.36 mol) of triethylamine was added dropwise to the mixture by using the dropping funnel over about one hour. After the dripping was finished, the ice-water bath was removed and the mixture was stirred at ambient temperature for 30 minutes.

51.7 g (0.30 mol) of p-aminobenzenesulfonamide was added to the reaction mixture and the mixture was stirred for one hour while being heated at 70°C in an oil bath. After a reaction was finished, this mixture was poured into 1 litre of water while the water was stirred, and the resulting mixture was stirred for 30 minutes. This mixture was subjected to filtration to remove precipitate, which was then made into a slurry using 500 ml of water. Thereafter, the slurry was subjected to filtration and an obtained solid was dried to obtain a white solid of N-(p-aminosulfonylphenyl) methacrylamide (yield: 46.9 g).

Next, a 20 ml three-neck flask equipped with a stirrer, a condenser tube, and a dropping funnel was charged with 4.61 g (0.0192 mol) of the N-(p-aminosulfonylphenyl) methacrylamide, 2.58 g (0.0258 mol) of ethylmethacrylate, 0.80 g (0.015 mol) of acrylonitrile and 20 g of N,N-dimethylacetamide and this mixture was stirred at 65°C under heating in a hot water bath. 0.15 g of "V-65" (manufactured by Wako Pure Chemical Industries) was added to the mixture and the resulting mixture was stirred in a nitrogen stream for 2 hours while being kept at 65°C. A mixture of 4.61 g of N-(p-aminosulfonylphenyl)methacrylamide, 2.58 g of methylmethacrylate, 0.80 g of acrylonitrile, 20 g of N,N-dimethylacetamide and 0.15 g of "V-65" was further added dropwise to the reaction mixture over 2 hours using the dropping funnel. After the dripping was finished, the resulting mixture was further stirred at 65°C for 2 hours. After completion of a reaction, 40 g of methanol was added to the mixture, which was then cooled, and the resulting mixture was poured into 2 litres of water while the water was stirred. After this mixture was stirred for 30 minutes, a precipitate was taken out by filtration and dried to obtain 15 g of a white solid of a copolymer 1. The weight average molecular weight (polystyrene base) of this specified copolymer 1 was measured by gel permeation chromatography and the average molecular weight was found to be 54,000.

*Production of a support*

A 0.3-mm thick aluminum plate was washed with trichloroethylene to degrease. Then the surface of the aluminum plate was pebbled using a nylon brush and a 400 mesh pumice/water suspension and was then thoroughly washed with

water. This plate was immersed in an aqueous 25% sodium hydroxide solution at 45°C for 9 seconds to carry out etching, followed by washing with water. The plate was further immersed in a 20% nitric acid solution for 20 seconds and then washed with water. At this time, the amount of etching of the pebbled surface was about 3 g/$m^2$. Next, the plate was formed with a 3 g/$m^2$ d.c. anodic oxidation film, using 7% sulfuric acid as an electrolyte at a current density of 15 A/$dm^2$. After that, the plate was washed with water and dried. The resulting plate was treated in an aqueous solution of 2.5% by weight of sodium silicate at 30°C for 10 seconds and coated with the following undercoat solution. The film was dried at 80°C for 15 seconds to obtain a support. The amount of the film applied was 15 mg/$m^2$ after drying.

Undercoat solution 2

| | |
|---|---|
| ˙ Random copolymer P (shown below) having a molecular weight of 28, 000 | 0.3 g |
| ˙ Methanol | 100 g |
| ˙ Water | 1 g |

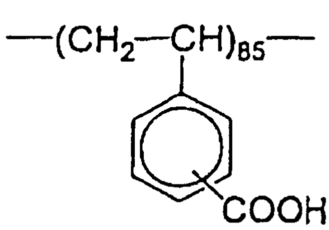 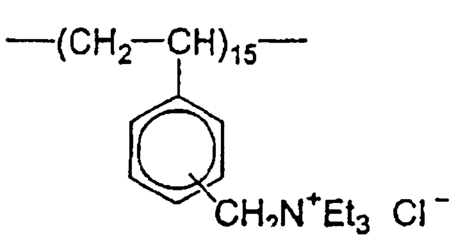

Structural units of random copolymer P

The following light-sensitive solution was prepared. The resulting support was coated with this light-sensitive solution such that the amount of the light-sensitive solution to be applied was 1.2 g/$m^2$, to obtain planographic printing master plates 7 to 10. Among these planographic printing master plates 7 to 10, those using light-sensitive solutions 7 to 9 using a recurring xylenol unit-containing novolac resin were designated as Examples 6 to 8 respectively. Also, a planographic printing master plate produced using a light-sensitive solution 10 containing a known novolac resin was obtained and designated as Comparative Example 2.

Light-sensitive solutions 7 to 10

| | |
|---|---|
| ˙ Fluorine-containing polymer (the structure shown below) | 0.03 g |
| ˙ Copolymer 1 | 0.75 g |
| ˙ Novolac resin (resin described in Table 3) | 0.25 g |
| ˙ p-Toluenesulfonic acid | 0.003 g |
| ˙ Tetrahydrophthalic acid anhydride | 0.03 g |
| ˙ Pyrylium dye B (the structure shown below) | 0.017 g |
| ˙ Dye in which the counter ion of Victoria Pure Blue BOH was 1-naphthalenesulfonic acid anion | 0.015 g |
| ˙ 3-methoxy-4-diazodiphenylaminehexafluorophosphate | 0.02 g |
| ˙ n-Dodecyl stearate | 0.03 g |
| ˙ Fluorine type surfactant (Product name: Megafac F-177, manufactured by Dainippon Ink and Chemicals) | 0.05 g |
| ˙ γ-butyrolactone | 10 g |
| ˙ Methyl ethyl ketone | 10 g |
| ˙ 1-Methoxy-2-propanol | 8 g |

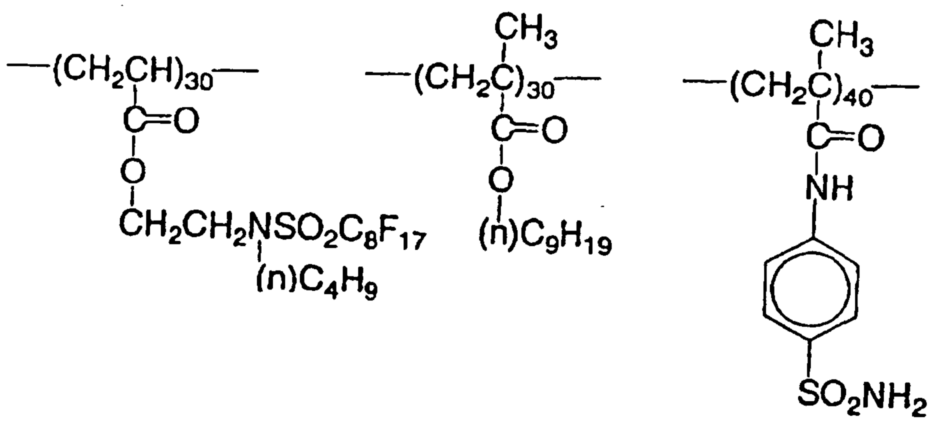

Fluorine-containing polymer

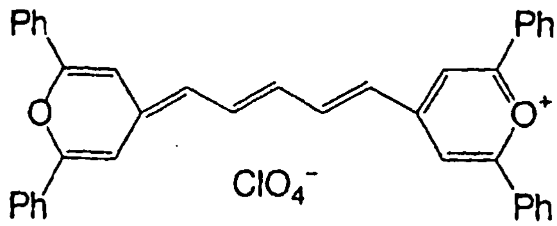

Pyrylium dye B

Table 3

| | Planographic printing plate | Light-sensitive solution | Novolac resin |
|---|---|---|---|
| Example 6 | Planographic printing plate 7 | Light-sensitive solution 7 | Novolac resin 2 |
| Example 7* | Planographic* printing plate 8 | Light-sensitive* solution 8 | Novolac resin 3* |
| Example 8 | Planographic printing plate 9 | Light-sensitive solution 9 | Novolac resin 4 |
| Comparative Example 2 | Planographic printing plate 10 | Light-sensitive solution 10 | Novolac resin 6 |
| *Reference Example-not part of the invention | | | |

Examples 9 to 11, Comparative Example 3

*Production of a support*

A 0.3-mm thick aluminum plate was washed with trichloroethylene to degrease. Then the surface of the aluminum plate was pebbled using a nylon brush and a 400 mesh pumice/water suspension and was then thoroughly washed with water. This plate was immersed in an aqueous 25% sodium hydroxide solution at 45°C for 9 seconds to carry out etching, followed by washing with water. The plate was further immersed in a 20% nitric acid solution for 20 seconds and then washed with water. At this time, the amount of etching of the pebbled surface was about 3 $g/m^2$. Next, the plate was

formed with a 3 $g/m^2$ d.c. anodic oxidation film, using 7% sulfuric acid as an electrolyte at a current density of 15 $A/dm^2$. After that, the plate was washed with water and dried and further coated with the aforementioned undercoat solution 2. The film was dried at 90°C for one minute. The amount of the film applied was 10 $mg/m^2$ after drying.

The resulting support was coated with the following light-sensitive solution 11A and dried at 100°C for 2 minutes to form a layer (A) . The amount to be applied was 1.3 $g/m^2$ after it was dried.

After that, the following light-sensitive solutions 11B to 14B were respectively applied and dried at 100°C for 2 minutes to form a layer (B) (upper layer) and obtain planographic printing master plates 11 to 14. The total amount of each light-sensitive solution after drying was 1.8 $g/m^2$. Among these planographic printing master plates, those using the light-sensitive solutions 11B to 13B using a recurring xylenol unit-containing novolac resin were designated as Examples 9 to 11 respectively. Also, a planographic printing master plate produced using the light-sensitive solution 10 containing a known novolac resin was designated as Comparative Example 3.

Light-sensitive solution 11A

| | |
|---|---|
| · Copolymer 1 | 0.75 g |
| · Cyanine dye A | 0.04 g |
| · p-Toluenesulfonic acid | 0.002 g |
| · Tetrahydrophthalic acid anhydride | 0.05 g |
| · Dye in which the counter ion of Victoria Pure Blue BOH was 1-naphthalenesulfonic acid anion | 0.015 g |
| · Fluorine type surfactant | 0.02 g |
| (Product name: Megafac F-177, manufactured by Dainippon Ink and Chemicals) | |
| · γ-butyrolactone | 8 g |
| · Methyl ethyl ketone | 7 g |
| · 1-Methoxy-2-propanol | 7 g |

Light-sensitive solutions 11B to 14B

| | |
|---|---|
| · Novolac resin (resin described in Table 4) | 0.25 g |
| · Pyrylium dye B | 0.05 g |
| · n-Dodecyl stearate | 0.02 g |
| · Fluorine type surfactant | 0.05 g |
| (Product name: Megafac F-177, manufactured by Dainippon Ink and Chemicals) | |
| · Methyl ethyl ketone | 7 g |
| · 1-Methoxy-2-propanol | 7 g |

Table 4

| | Planographic printing plate | Light-sensitive solution | Novolac resin |
|---|---|---|---|
| Example 9 | Planographic printing plate 11 | Light-sensitive solution 11 | Novolac resin 2 |
| Example 10* | Planographic* printing plate 12 | Light-sensitive* solution 12 | Novolac resin 3* |
| Example 11 | Planographic printing plate 13 | Light-sensitive solution 13 | Novolac resin 4 |
| Comparative Example 3 | Planographic printing plate 14 | Light-sensitive solution 14 | Novolac resin 6 |
| *Reference Example - not part of the invention | | | |

*Evaluation of planographic printing master plates*

The resulting planographic printing master plates of Examples 6 to 11 and Comparative Examples 2 and 3 were stored and exposed with the same method as for Example 1 and developed by the following method to evaluate sensitivity and aging stability.

*Developing treatment*

20 litres of an alkali developing process solution C (pH: about 13) or an alkali developing process solution D (pH: about 13.2) respectively having the following compositions was filled into a developing process vessel of a commercially available automatic developing machine LP-900H (manufactured by Fuji Photo Film Co., Ltd.) provided with

a dipping-type developing vessel and kept at 30°C. 8 litres of tap water was laid in a second bath of the LP-900H and a finishing gum solution prepared by diluting FP-2W (manufactured by Fuji Photo Film Co., Ltd.) with water (1:1) was laid in a third bath of the LP-900H. The exposed planographic printing plates 7 to 14 were each developed in the automatic developing machine provided with a developing process solution suitable to the planographic printing plate. The alkali developing process solutions used here and the results of evaluation are shown in Table 5 below.

Composition of the alkali developing process solution C

| | |
|---|---|
| · D sorbitol | 2.5% by weight |
| · Sodium hydroxide | 0.85% by weight |
| · Diethylenetriaminepenta(methylenephosphonic acid)5 Na salt | 0.05% by weight |
| · Water | 96.6% by weight |

Composition of the alkali developing process solution D

| | |
|---|---|
| · D sorbitol | 5.0% by weight |
| · Sodium hydroxide | 1.7% by weight |
| · Diethylenetriaminepenta(methylenephosphonic acid)5 Na salt | 0.1% by weight |
| · Water | 93.2% by weight |

Table 5

| | Clear sensitivity ($mJ/cm^2$) | | | |
|---|---|---|---|---|
| | Alkali developing process solution C | | Alkali developing process solution D | |
| | Ambient temperature aging | 45°C, 75% humidity aging | Ambient temperature aging | 45°C, 75% humidity aging |
| Example 6 | 56 | 61 | - | - |
| Example 7* | - | - | 56 | 61 |
| Example 8 | 51 | 61 | - | - |
| Comparative Example 2 | 72 | 122 | - | - |
| Example 9 | 56 | 61 | - | - |
| Example 10* | - | - | 61 | 67 |
| Example 11 | 51 | 56 | - | - |
| Comparative Example 3 | 79 | 145 | - | - |
| *Reference Example - not part of the invention | | | | |

As is clear from Table 5, the planographic printing master plate according to the present invention had high sensitivity and excellent stability over time. On the other hand, the Comparative Examples, provided with light-sensitive layers having the same structure as the Examples except that conventionally known novolac resin was used, had insufficient storage stability.

The planographic printing master plate of the present invention produces effects of high sensitivity, limited reduction in sensitivity over time and high stability with time.

## Claims

1. A light-sensitive image-forming composition comprising an alkali - soluble resin containing a novolac resin, a material which absorbs light and generates heat, and a solvent,
wherein the novolac resin comprises recurring units derived from at least one xylenol selected from the group

consisting of 3,5-xylenol and 2,3-xylenol,
and wherein the material which absorbs light and generates heat is a dye or pigment.

2. The light-sensitive image-forming composition according to claim 1, wherein the novolac resin has a weight average molecular weight of from 500 to 10,000.

3. The light-sensitive image-forming composition according to claim 1, wherein
if a percent-by-weight proportion of the recurring xylenol unit-containing novolac resin in the alkali-soluble resin is Y% by weight, and the content of the xylenol units in the recurring xylenol unit-containing novolac resin is X% by weight, then $x \times y \geq 500$.

4. The light-sensitive image-forming composition according to claim 1, wherein the novolac resin, which contains the recurring xylenol units, makes up 20% to 90% by weight of total solids of the light-sensitive image-forming composition.

5. A positive planographic printing plate comprising a support and a light-sensitive layer formed on the support, the light-sensitive layer comprising an alkali - soluble resin containing a novolac resin and a material which absorbs light and generates heat,
wherein the novolac resin comprises recurring units derived from at least one xylenol selected from the group consisting of 3,5-xylenol and 2,3-xylenol,
and wherein the material which absorbs light and generates heat is a dye or pigment.

6. The positive planographic printing plate according to claim 5, wherein the novolac resin makes up 20% to 90% by weight of total solids in the light-sensitive layer.

7. The positive planographic printing plate according to claim 5, wherein the novolac resin has a weight average molecular weight of from 500 to 10,000.

8. The positive planographic printing plate according to claim 5, wherein
if a percent-by-weight proportion of the recurring xylenol units-containing novolac resin in the alkali-soluble resin is Y% by weight, and the content of the xylenol units in the recurring xylenol units-containing novolac resin is X% by weight, then $x \times y \geq 500$

## Patentansprüche

1. Lichtempfindliche, bildgebende Zusammensetzung, die ein alkalilösliches Harz, das ein Novolakharz enthält, ein Material, welches Licht absorbiert und Wärme generiert, und ein Lösungsmittel umfasst,
worin das Novolakharz Wiederholungseinheiten umfasst, die aus mindestens einem Xylenol abgeleitet sind, welches ausgewählt ist aus der Gruppe bestehend aus 3,5-Xylenol und 2,3-Xylenol,
und worin das Material, welches Licht absorbiert und Wärme generiert, ein Farbstoff oder Pigment ist.

2. Lichtempfindliche, bildgebende Zusammensetzung gemäß Anspruch 1, worin das Novolakharz ein gewichtsgemitteltes Molekulargewicht von 500 bis 10.000 aufweist.

3. Lichtempfindliche, bildgebende Zusammensetzung gemäß Anspruch 1, worin, wenn der Anteil in Gewichtsprozent des Novolakharzes, das Xylenol-Wiederholungseinheiten enthält, in dem alkalilöslichen Harz Y Gew.% ist, und der Gehalt der Xylenoleinheiten in dem Novolakharz, das Xylenol-Wiederholungseinheiten enthält, X Gew.% ist, dann $x \times y \geq 500$ erfüllt ist.

4. Lichtempfindliche, bildgebende Zusammensetzung gemäß Anspruch 1, worin das Novolakharz, das die Xylenol-Wiederholungseinheiten enthält, 20 bis 90 Gew.% der gesamten Feststoffe der lichtempfindlichen, bildgebenden Zusammensetzung bildet.

5. Positive Flachdruckplatte, umfassend einen Träger und eine auf dem Träger gebildete lichtempfindliche Schicht, wobei die lichtempfindliche Schicht ein alkalilösliches Harz, das ein Novolakharz umfasst, und ein Material, welches Licht absorbiert und Wärme generiert, umfasst,
worin das Novolakharz Wiederholungseinheiten aufweist, die aus mindestens einem Xylenol abgeleitet sind, ausgewählt aus der Gruppe bestehend aus 3,5-Xylenol und 2,3-Xylenol,
und worin das Material, welches Licht absorbiert und Wärme generiert, ein Farbstoff oder Pigment ist.

**6.** Positive Flachdruckplatte gemäß Anspruch 5, worin das Novolakharz 20 bis 90 Gew.% der gesamten Feststoffe in der lichtempfindlichen Schicht bildet.

**7.** Positive Flachdruckplatte gemäß Anspruch 5, worin das Novolakharz ein gewichtsgemitteltes Molekulargewicht von 500 bis 10.000 aufweist.

**8.** Positive Flachdruckplatte gemäß Anspruch 5, worin, wenn der Anteil in Gewichtsprozent des Novolakharzes, das Xylenol-Wiederholungseinheiten aufweist, in dem alkalilöslichen harz Y Gew.% ist und der Gehalt der Xylenoleinheiten in dem Novolakharz, das Xylenol-Wiederholungseinheiten enthält, X Gew.% ist, dann $x \times y \geq 500$ erfüllt ist.

## Revendications

**1.** Composition de formation d'image sensible à la lumière comprenant une résine soluble dans l'alcali contenant une résine novolaque, une matière qui absorbe de la lumière et génère de la chaleur, et un solvant,
dans laquelle la résine novolaque comprend des unités récurrentes dérivées d'au moins un xylénol sélectionné à partir du groupe constitué par le 3,5-xylénol et le 2,3-xylénol,
et dans laquelle la matière qui absorbe de la lumière et génère de la chaleur est une teinture ou un pigment.

**2.** Composition de formation d'image sensible à la lumière selon la revendication 1, dans laquelle la résine novolaque a une masse moléculaire moyenne en poids de 500 à 10 000.

**3.** Composition de formation d'image sensible à la lumière selon la revendication 1, dans laquelle
si une proportion de pourcentage en poids de la résine novolaque contenant une unité de xylénol récurrente dans la résine soluble dans l'alcali est de Y % en poids, et si la teneur des unités de xylénol dans la résine novolaque contenant une unité de xylénol récurrente est de X% en poids, alors $x \times y \geq 500$.

**4.** Composition de formation d'image sensible à la lumière selon la revendication 1, dans laquelle la résine novolaque, qui contient les unités de xylénol récurrentes, constitue 20 % à 90 % en poids des solides totaux de la composition de formation d'image sensible à la lumière.

**5.** Plaque d'impression planographique positive comprenant un support et une couche sensible à la lumière formée sur le support, la couche sensible à la lumière comprenant une résine soluble dans l'alcali contenant une résine novolaque et une matière qui absorbe de la lumière et génère de la chaleur,
dans laquelle la résine novolaque comprend des unités récurrentes obtenues à partir d'au moins un xylénol sélectionné à partir du groupe constitué par le 3,5-xylénol et le 2,3-xylénol,
et dans laquelle la matière qui absorbe de la lumière et génère de la chaleur est une teinture ou un pigment.

**6.** Plaque d'impression planographique positive selon la revendication 5, dans laquelle la résine novolaque constitue 20 % à 90 % en poids de solides totaux dans la couche sensible à la lumière.

**7.** Plaque d'impression planographique positive selon la revendication 5, dans laquelle la résine novolaque a une masse moléculaire moyenne en poids de 500 à 10 000.

**8.** Plaque d'impression planographique positive selon la revendication 5, dans laquelle
si une proportion de pourcentage en poids de la résine novolaque contenant des unités de xylénol récurrentes dans la résine soluble dans l'alcali est de Y % en poids, et si la teneur des unités de xylénol dans la résine novolaque contenant des unités de xylénol récurrentes est de X % en poids, alors $x \times y \geq 500$.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 7285275 A
- WO 9739894 A
- EP 0823327 A2
- EP 0823327 A
- EP 0950517 A
- WO 0029214 A
- EP 0943451 A
- EP 0900653 A
- EP 0997272 A
- WO 9921715 A
- JP 51034711 A
- JP 2000866 A
- JP 63124047 A
- JP 63261350 A
- JP 63287942 A
- JP 63287943 A
- JP 63287944 A
- JP 63287946 A
- JP 63287947 A
- JP 63287948 A
- JP 63287949 A
- JP 1134354 A
- JP 1255854 A
- JP 58125246 A
- JP 59084356 A
- JP 59202829 A
- JP 60078787 A
- JP 58173696 A
- JP 58181690 A
- JP 58194595 A
- JP 58112793 A
- JP 58224793 A
- JP 59048187 A
- JP 59073996 A
- JP 60052940 A
- JP 60063744 A
- JP 58112792 A
- GB 434875 A
- US 5380635 A
- US 5156938 A
- US 3881924 A
- JP 57142645 A
- US 4327169 A
- JP 58181051 A
- JP 58220143 A
- JP 59041363 A
- JP 59084248 A
- JP 59084249 A
- JP 59146063 A
- JP 59146061 A
- JP 59216146 A
- US 4283475 A
- JP 5013514 B
- JP 5019702 B
- US 4756993 A
- JP 5158230 A
- US 4069055 A
- US 4069056 A
- JP 3140140 A
- EP 104143 A
- US 4339049 A
- US 4410201 A
- JP 2150848 A
- JP 2296514 A
- EP 370693 A
- EP 233567 A
- EP 297443 A
- EP 297442 A
- US 4933377 A
- US 3902114 A
- US 4760013 A
- US 4734444 A
- US 2833827 A
- DE 2904626
- DE 3604580
- DE 3604581
- US 4115128 A
- JP 60088942 A
- JP 2096755 A
- JP 62251740 A
- JP 3208514 A
- JP 59121044 A
- JP 4013149 A
- JP 50036209 A
- JP 53008128 A
- JP 53036223 A
- JP 54074728 A
- JP 60003626 A
- JP 61143748 A
- JP 61151644 A
- JP 63058440 A
- JP 62293247 A
- JP 62170950 A
- JP 54063902 A
- US 2714066 A
- US 3181461 A
- US 3280734 A
- US 3902734 A

- JP 3622063 B
- US 3276868 A
- US 4153461 A
- US 4689272 A
- JP 54062004 A
- JP 57007427 B
- JP 2013293 B
- JP 59174842 A
- JP 61002518 B
- JP 55028062 B
- JP 62031859 A
- JP 61159655 A

**Non-patent literature cited in the description**


- Color Index (C.I.) Handbook. Latest Pigment Handbook. 1977
- Latest Pigment Applied Technology. CMC Shuppan, 1986
- Printing Ink Technology. CMC Shuppan, 1984
- Qualities and Applications of Metal Soaps. Printing Ink Technology. CMC Shuppan, 1984
- Dye Handbook. 1970
- **S.I. Schlesinger.** *Photogr. Sci. Eng.,* 1974, vol. 18, 387
- **T.S. Bal et al.** *Polymer,* 1980, vol. 21, 423
- **D.C. Necker et al.** *Macromolecules,* 1984, vol. 17, 2468
- **C.S. Wen et al.** *Teh, Proc. Conf. Rad. Curing ASIA,* October 1988, 478
- **J.V. Crivello et al.** *Macromolecules,* 1977, vol. 10 (6), 1307
- *Chem. & Eng. News,* 28 November 1988, 31
- **J.V. Crivello et al.** *Polymer J.,* 1985, vol. 17, 73
- **J.V. Crivello et al.** *J. Org. Chem.,* 1978, vol. 43, 3055
- **W.R. Watt et al.** *J. Polymer Sci., Polymer Chem. Ed.,* 1984, vol. 22, 1789
- **J.V. Crivello et al.** *Polymer Bull.,* 1985, vol. 14, 279
- **J.V. Crivello et al.** *Macromolecules,* 1981, vol. 14 (5), 1141
- **J.V. Crivello et al.** *J. Polymer Sci., Polymer Chem. Ed.,* 1979, vol. 17, 2877
- **J.V. Crivello et al.** *J. Polymer Sci., Polymer Chem. Ed.,* 1979, vol. 17, 1047